(19) Europäisches Patentamt
European Patent Office
Office européen des brevets

(11) **EP 4 773 505 A1**

(12) **EUROPEAN PATENT APPLICATION**
published in accordance with Art. 153(4) EPC

(43) Date of publication:
**08.07.2026 Bulletin 2026/28**

(21) Application number: **24920943.8**

(22) Date of filing: **01.02.2024**

(51) International Patent Classification (IPC):
*H03F 3/213* *(2006.01)*

(52) Cooperative Patent Classification (CPC):
**H03F 1/02; H03F 1/56; H03F 3/213**

(86) International application number:
**PCT/CN2024/075168**

(87) International publication number:
**WO 2025/160877 (07.08.2025 Gazette 2025/32)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Suzhou Watech Electronics Co., Ltd.
Suzhou, Jiangsu 215125 (CN)**

(72) Inventor: **YANG, Mengsu
Suzhou, Jiangsu 215125 (CN)**

(74) Representative: **Michalski Hüttermann & Partner
mbB
Kaistraße 16A
40221 Düsseldorf (DE)**

(54) **DOHERTY POWER AMPLIFIER**

(57) The present disclosure provides a Doherty power amplifier. The Doherty power amplifier comprises an input power distribution module, a phase shift module, an amplification module, and an output power combination module. The input power distribution module comprises a first power division circuit and a second power division circuit. A first end of a first power division capacitor in the first power division circuit is electrically connected to a signal input node, and a second end of the first power division capacitor is electrically connected to a first power division output node; a first end of a second power division capacitor in the second power division circuit is electrically connected to the signal input node, and a second end of the second power division capacitor is electrically connected to a second power division output node. The first power division capacitor and the second power division capacitor may be integrated lumped capacitors. In addition, the output power combination module comprises a compensation inductor, and the compensation inductor may be a surface mount inductor.

Fig. 2

EP 4 773 505 A1

**Description**

TECHNICAL FIELD

The present disclosure relates to the technical field of power amplifiers, and more particularly to a Doherty power amplifier having an integrating input and a non-integrating output.

BACKGROUND

As a common power amplifier architecture, a Doherty power amplifier can provide a high-efficiency amplification for modulated signals with a high peak-to-average ratio. In general, a two-channel Doherty power amplifier comprises a two-channel power amplifying architecture comprising a main amplifier and a peak amplifier. A multi-channel Doherty power amplifier is based on a two-channel Doherty architecture and introduces additional peak amplifiers to further enhance efficiency. For example, a three-channel Doherty power amplifier comprises a main amplifier, a first peak amplifier, and a second peak amplifier to form a three-channel power amplifier architecture.

The development of 5G technology puts a higher requirement for the power amplifier, and high integration and high performance are two important aspects. For improving integration, microwave monolithic integrated circuits (i.e., MMIC) are adopted. However, a high-integrated MMIC power amplifier is usually based on a silicon process, and the low resistivity of the silicon substrate results in a low quality factor (i.e., Q factor) of the integrated lumped inductor, leading to increased losses and an unfavorable influence on gain and efficiency of the circuit. In addition, the topology structure of a common integrated lumped inductor is a planar spiral inductor, which usually occupies a larger area, increasing chip sizes, not conducive to reducing costs, increasing losses, and decreasing the gain of the power amplifier. Furthermore, in terms of improving performance, for the output power combining module of the Doherty power amplifier, an integrated lumped inductor based on a silicon process is not appropriate, due to large losses at the output end to seriously drag down the efficiency. Currently, for application scenarios with low inductance, output ends usually adopt bonding wires to realize inductors. However, the quality factor of the bonding wires wrapped with epoxy resin is only about 30. For solving the reflow losses through the silicon substrates, shielding plates are required to be disposed under the bonding wires to improve losses, so that the chip sizes are enlarged, and not conducive to reducing costs.

SUMMARY

According to a first aspect of the embodiment of the disclosure, a Doherty power amplifier is provided and comprises an input power dividing module, a phase shifting module, an amplifying module, and an output power combining module. The input power dividing module comprises a first power dividing circuit and a second power dividing circuit. A first end of a first power dividing capacitor of the first power dividing circuit is electrically connected to a signal input node, and a second end of the first power dividing capacitor is electrically connected to a first power dividing output node. A first end of a second power dividing capacitor of the second power dividing circuit is electrically connected to the signal input node, and a second end of the second power dividing capacitor is electrically connected to a second power dividing output node. A phase shifting module is configured to: receive a first power dividing output signal from the first power dividing output node and output a first phase shifting output signal at a first phase shifting output node, and receive a second power dividing output signal from a second power dividing output node and output a second phase shifting output signal at a second phase shifting output node, wherein a phase of the second phase shifting output signal lags to a phase of the first phase shifting output signal by a preset phase value. The amplifying module comprises a main amplifier and a first peak amplifier. The main amplifier is configured to: receive the first phase shifting output signal, and output the main amplifying signal at the main amplifying signal output node; and the first peak amplifier is configured to: receive the second phase shifting output signal, and output the first peak amplifying signal at the first peak amplifying signal output node. The output power combining module is configured to: receive the main amplifying signal and the first peak amplifying signal, make a phase of the main amplifying signal and a phase of the first peak amplifying signal the same, and combine and output the main amplifying signal and the first peak amplifying signal.

According to some exemplary embodiments, the first power dividing capacitor and the second power dividing capacitor are integrated lumped capacitors.

According to some exemplary embodiments, the phase shifting module comprises a phase shifting capacitor, a first end of the phase shifting capacitor is electrically connected to the first power dividing output node, a second end of the phase shifting capacitor is electrically connected to the first phase shifting output node, and the phase shifting module makes the second power dividing output node and the second phase shifting output node electrically connected.

In some exemplary embodiments, the phase shifting capacitor can be an integrated lumped capacitor.

According to some exemplary embodiments, the phase shifting module makes the first power dividing output node and the first phase shifting output node electrically connected, and the phase shifting module comprises a phase shifting inductor, a first end of the phase shifting inductor is electrically connected to the second phase shifting output node, and a second end of the phase shifting inductor is electrically connected to the second phase shifting output node.

In some exemplary embodiments, the phase shifting inductor is an integrated lumped inductor.

In some exemplary embodiments, the main amplifier comprises a first transistor, a gate electrode of the first transistor is electrically connected to the first phase shifting output node, a source electrode of the first transistor is grounded, and a drain electrode of the first transistor is electrically connected to the main amplifying signal output node. The first peak amplifier comprises a second transistor, a gate electrode of the second transistor is electrically connected to the second phase shifting output node, a source electrode of the second transistor is grounded, and a drain electrode of the second transistor is electrically connected to the first peak amplifying signal output node.

In some exemplary embodiments, the output power combining module comprises a compensation inductor, a first end of the compensation inductor is electrically connected to the main amplifying signal output node, and a second end of the compensation inductor is electrically connected to the first peak amplifying signal output node.

According to some exemplary embodiments, the compensation inductor is a surface-mount inductor.

According to some exemplary embodiments, in the Doherty power amplifier according to the first aspect of the embodiment of the disclosure, the input power dividing module further comprises a third power dividing circuit, a first end of a third power dividing capacitor of the third power dividing circuit is electrically connected to the signal input node, and a second end of the third power dividing capacitor is electrically connected to a third power dividing output node; the phase shifting module further configured to: receive the third power dividing output signal from the third power dividing output node and output the third phase shifting output signal at the third phase shifting output signal node, where a phase of the third phase shifting output signal lags to a phase of the second phase shifting output signal the preset phase value; the amplifying module further comprises a second peak amplifier, configured to: receive the third phase shifting output signal, and output a second peak amplifying signal at the second peak amplifying signal output node; and the output power combining module, further configured to : receive the second peak amplifying signal, make a phase of the main amplifying signal, a phase of the first peak amplifying signal and a phase of the second peak amplifying signal the same, and combine and output the main amplifying signal, the first peak amplifying, and the second peak amplifying signal.

According to some exemplary embodiments, the first power dividing capacitor, the second power dividing capacitor, and the third power dividing capacitor are integrated lumped capacitors.

According to some exemplary embodiments, the phase shifting module comprises a phase shifting capacitor and a phase shifting inductor, a first end of the phase shifting capacitor is electrically connected to the first power dividing output node, a second end of the phase shifting capacitor is electrically connected to the first phase shifting output node, a first end of the phase shifting inductor is electrically connected to the third power dividing output node, a second end of the phase shifting inductor is electrically connected to the third phase shifting output node, and the phase shifting module makes the second power dividing output node to conduct with the second phase shifting output node.

According to some exemplary embodiments, the phase shifting capacitor is an integrated lumped capacitor, and the phase shifting inductor is an integrated lumped inductor.

According to some exemplary embodiments, the phase shifting module comprises a first phase shifting inductor and a second phase shifting inductor, a first end of the first phase shifting inductor is electrically connected to the second power dividing output node, a second end of the first phase shifting inductor is electrically connected to the second phase shifting output node, a first end of the second phase shifting inductor is electrically connected to the third power dividing output node, a second end of the second phase shifting inductor is electrically connected to the third phase shifting output node, and the phase shifting module makes the first power dividing output node to conduct with the first phase shifting output node.

In some exemplary embodiments, the first phase shifting inductor and the second phase shifting inductor are integrated lumped capacitors.

In some exemplary embodiments, the second phase shifting inductor is formed by two integrated lumped inductors in series.

In some exemplary embodiments, the main amplifier comprises a first transistor, a gate electrode of the first transistor is electrically connected to the first phase shifting output node, a source electrode of the first transistor is grounded, and a drain electrode of the first transistor is electrically connected to the main amplifying signal output node. The first peak amplifier comprises a second transistor, a gate electrode of the second transistor is electrically connected to the second phase shifting output node, a source electrode of the second transistor is grounded, and a drain electrode of the second transistor is electrically connected to the first peak amplifying signal output node. The second peak amplifier comprises a third transistor, a gate electrode of the third transistor is electrically connected to the third phase shifting output node, a source electrode of the third transistor is grounded, and a drain electrode of the third transistor is electrically connected to the second peak amplifying signal output node.

According to some exemplary embodiments, the output power combining module comprises a first compensation inductor and a second compensation inductor, a first end of the first compensation inductor is electrically connected to the main amplifying signal output node, a second end of the first compensation inductor is electrically connected to the first peak amplifying signal output node, a first end of the second compensation inductor is electrically connected to the first peak amplifying signal output node, a second end of the second compensation inductor is electrically connected to the second peak amplifying signal output node, and an inductance value of the first compensation inductor is greater than an inductance value of the second compensation inductor.

According to some exemplary embodiments, at least one of the first compensation inductor and the second compensation inductor is a surface-mount inductor.

According to some exemplary embodiments, the preset value ranges from 60° to 100°.

BRIEF DESCRIPTION OF THE DRAWINGS

In the following, exemplary embodiments of the present disclosure will be described in detail with reference to the accompanying drawings, where:

Fig. 1 schematically illustrates a power dividing and phase shifting circuit of a conventional Doherty power amplifier;

Fig. 2 schematically illustrates a Doherty power amplifier according to some exemplary embodiments of the present disclosure;

Fig. 3 schematically illustrates a Doherty power amplifier according to some exemplary embodiments of the present disclosure;

Fig. 4 schematically illustrates a Doherty power amplifier according to some exemplary embodiments of the present disclosure;

Fig. 5 schematically illustrates a Doherty power amplifier according to some exemplary embodiments of the present disclosure;

Fig. 6 schematically illustrates a Doherty power amplifier according to some exemplary embodiments of the present disclosure;

Fig. 7 illustrates the relationship between the inductance value of the compensation inductor and the operating frequency;

Fig. 8 and Fig. 9 illustrate comparison results between a Doherty power amplifier according to the present disclosure and a conventional Doherty power amplifier in power distribution and phase shifting;

Fig. 10 and Fig. 11 illustrate comparison results between another Doherty power amplifier according to the present disclosure and a conventional Doherty power amplifier in power distributing and phase shifting;

Fig. 12 schematically illustrates a Doherty power amplifier according to other exemplary embodiments of the present disclosure;

Fig. 13 schematically illustrates a Doherty power amplifier according to other exemplary embodiments of the present disclosure;

Fig. 14 schematically illustrates a Doherty power amplifier according to other exemplary embodiments of the present disclosure;

Fig. 15 schematically illustrates a Doherty power amplifier according to other exemplary embodiments of the present disclosure; and

Fig. 16 schematically illustrates a Doherty power amplifier according to other exemplary embodiments of the present disclosure.

It should be understood that the drawings are merely schematic illustrations of exemplary embodiments of the disclosure, and are not limitations to the disclosure, so they are not necessary to be drawn to scale. Furthermore, in the drawings, the same or similar features are denoted by the same or similar reference numerals.

DETAILED DESCRIPTION OF THE EMBODIMENTS

Various exemplary embodiments of the present disclosure are described below in conjunction with the drawings to enable those having ordinary skills in the art to fully understand and implement the technical solutions according to the present disclosure.

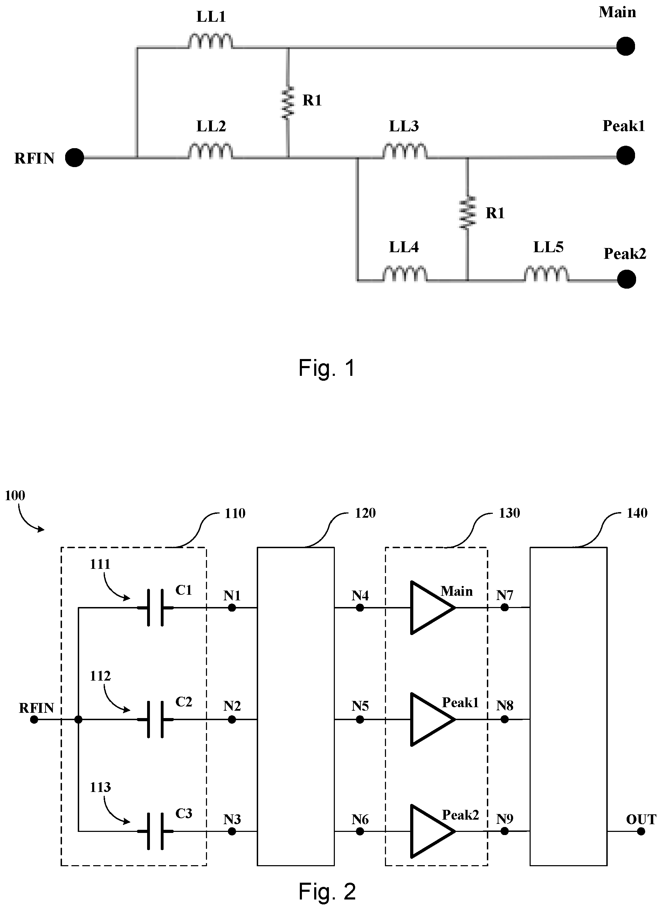

Fig. 1 schematically illustrates a power dividing and phase shifting circuit of a conventional Doherty power amplifier. A power dividing and phase shifting circuit shown in Fig. 1 can be applied in a three-channel Doherty power amplifier. The power dividing and phase shifting circuit divides a signal to be amplified and input from the signal input node RFIN into three signals with preset power and phase, and transmits the three signals to the main amplifier Main, the first peak amplifier Peak1, and the second peak amplifier Peak2, respectively, for subsequent amplification and processes such as combining the amplified signals and outputting. The power dividing and phase shifting circuit is formed by five inductors, LL1, LL2, LL3, LL4, LL5, and two resistors, R1, R2. Specifically, the inductors LL1, LL2, and the resistor R1 form a first-stage two-channel power divider, and the inductors LL3, LL4, and the resistor R2 form a second-stage two-channel power divider. The inductor LL1 forms a first phase shifting circuit, the inductors LL2 and LL3 form a second phase shifting circuit, and the inductors LL2, LL4, and LL5 form a third phase shifting circuit. The power dividing and phase shifting circuit requires five planar spiral inductors, enlarging the chip sizes, not conducive to reducing costs, increasing losses, and decreasing the gain of the power amplifier.

Referring to Fig.2, Fig. 2 schematically illustrates a Doherty power amplifier according to some exemplary embodiments of the present disclosure. As shown in Fig. 2, the Doherty power amplifier 100 is a three-channel integrated Doherty power amplifier and comprises an input power dividing module 110, a phase shifting module 120, an amplifying module 130, and an output power combining module 140. The Doherty power amplifier 100 amplifies a signal to be amplified and input from the signal input node RFIN, and outputs the amplified signal at a signal output node OUT.

The input power dividing module 110 is configured to divide the signal to be amplified and input from the signal input node RFIN, according to a preset power distribution ratio, and output the divided signals through the corresponding power dividing circuits for processing by subsequent modules. In the Doherty power amplifier 100 as shown in Fig. 1, the input power dividing module 110 comprises a first power dividing circuit 111, a second power dividing circuit 112, and a third power dividing circuit 113. A first end of a first power dividing capacitor C1 of the first power dividing circuit 111 is electrically connected to the signal input node RFIN, and a second end of the first power dividing capacitor C1 is electrically connected to a first power dividing output node N1. A first end of a second power dividing capacitor C2 of the second power dividing circuit 112 is electrically connected to the signal input node RFIN, and the second end of the second power dividing capacitor C2 is electrically connected to a second power dividing output node N2. A first end of a third power dividing capacitor C3 of the third power dividing circuit 113 is electrically connected to the signal input node RFIN, and a second end of the third power dividing capacitor C3 is electrically connected to a third power dividing output node N3. In this way, the signal to be amplified and input from the signal input node RFIN, is divided into three signals with the required power, and transmitted to the subsequent circuit for processing by three power dividing circuits, respectively.

According to some exemplary embodiments, the first power dividing capacitor C1, the second power dividing capacitor C2, and the third power dividing capacitor C3 can be integrated lumped capacitors. It should be understood that any other appropriate capacitor is possible, and the embodiments of the present disclosure do not impose any restrictions on the specific type of capacitor to operate as a power dividing capacitor.

As non-limiting examples, the capacitance values of the first power dividing capacitor C1, the second power dividing capacitor C2, and the third power dividing capacitor C3 can be determined as follows. Take the Doherty power amplifier 100 for example as shown in Fig. 1, the output signal of the first power dividing circuit 111 is transmitted to the main amplifier Main, the output signal of the second power dividing circuit 112 is transmitted to the first peak amplifier Peak1 , and the output signal of the third power dividing circuit 113 is transmitted to the second peak amplifier Peak2. Assuming the power of the signal to be amplified and input at the signal input node RFIN is normalized to 1, the power ratio of the output signal of the first power dividing circuit 111 is R_M, the power ratio of the output signal of the second power dividing circuit 112 is R_P1, and the power ratio of the output signal of the third power dividing circuit 113 is R_P2. Then R_M + R_P1 + R_P2 =1. Assuming the center frequency of the input power dividing module 110 is f0, the characteristic impedance at the signal input node RFIN is Z0, then the capacitance values of the first power dividing capacitor C1, the second power dividing capacitor C2, and the third power dividing capacitor C3 are calculated by the following formulas:

$$C1 = \frac{1}{2\pi f_0 Z_0} \cdot \sqrt{\sqrt{\frac{R\_M^3}{1-R\_M}}}$$

Formula 1

$$C2 = \frac{1}{2\pi f_0 Z_0} \cdot \sqrt{\sqrt{\frac{R\_P1^3}{1-R\_P1}}}$$

Formula 2

$$C3 = \frac{1}{2\pi f_0 Z_0} \cdot \sqrt{\sqrt{\frac{R\_P2^3}{1 - R\_P2}}}$$

<div align="right">Formula 3</div>

Continue referring to Fig. 2, the phase shifting module 120 is configured to: receive signals output from first power dividing output node N1, the second power dividing output node N2, and the third power dividing output node N3, perform phase shifting processes, and then output the corresponding signals at the first phase shifting output node N4, the second phase shifting output node N5, and the third phase shifting node N6, respectively. Specifically, the phase shifting module 120 is configured to: receive a first power dividing output signal from the first power dividing output node N1 and then output a first phase shifting output signal at the first phase shifting output node N4, receive a second power dividing signal from the second power dividing node N2 and then output a second power dividing signal at the second phase shifting output node N5, and receive a third power dividing signal from the third power dividing output node N3 and then output a third power dividing signal at the third phase shifting node N6, where a phase of the second phase shifting output signal lags to a phase of the first phase shifting output signal by a preset phase value, and the phase of the third phase shifting output signal lags to the phase of the second phase shifting output signal by the preset phase value. According to some exemplary embodiments, the preset value ranges from 60° to 100°. It should be understood that the phase shifting module 120 can be implemented by any appropriate form of circuit configuration, provided it is capable of implementing the phase shifting processing described above for each power dividing output signal. The specific circuit configuration of the phase shifting module 120 is described in detail as follows.

The amplifying module 130 is configured to: receive the phase shifting output signals from the first phase shifting output node N4, the second phase shifting output node N5, and the third phase shifting output node N6, perform amplifying processes, and then output the corresponding signals at a main amplifying signal output node N7, a first peak amplifying signal output node N8, and a second peak amplifying signal output node N9, respectively. Specifically, the amplifying module 130 comprises the main amplifier Main, the first peak amplifier Peak1, and the second peak amplifier Peak2. The main amplifier Main is configured to: receive the first phase shifting output signal from the first phase shifting output node N4, and output the main amplifying signal at the main amplifying signal output node N7. The first peak amplifier Peak1 is configured to: receive the second phase shifting output signal from the second phase shifting output node N5, and output the first peak amplifying signal at the first peak amplifying signal output node N8. The second peak amplifier Peak2 is configured to: receive the third phase shifting output signal at the third phase shifting output node N6, and output the second peak amplifying signal at the second peak amplifying signal output node N9.

The output power combining module 140 is configured to: receive the main amplifying signal from the main amplifying signal output node N7, receive the first peak amplifying signal from the first peak amplifying signal output node N8, and receive the second peak amplifying signal from the second peak amplifying signal output node N9, make a phase of the main amplifying signal, a phase of the first peak amplifying signal, and a phase of the second peak amplifying signal the same phase, and combine and output at the main amplifying signal, the first peak amplifying signal, and the second peak amplifying signal from the signal output node OUT. It should be understood that the output power combining module 140 can be implemented by any appropriate form of circuit configuration, provided it is capable of implementing the combining and outputting described above for each amplifying signal. The specific circuit configuration of the output power combining module 140 is described in detail as follows.

In some exemplary embodiments, the input power dividing module 110 and the phase shifting module 120 are integrated in a die, the main amplifier Main, the first peak amplifier Peak1, and the second peak amplifier Peak2 are integrated in another die, and the latter die can be electrically connected to the former die by bonding wires. In other exemplary embodiments, the input power dividing module 110 and the phase shifting module 120 are integrated in different dies, and the different dies are electrically connected by bonding wires. Furthermore, the same die or different dies described above can be in a single package, and the output power combining module 140 is implemented in a non-integrated way, for example, connecting to the package by bonding wires or through holes.

By the above analysis, the Doherty power amplifier 100 as shown in Fig. 2 utilizes capacitors to implement the input power dividing module 110 and avoids utilizing inductors, thus the chip sizes are reduced, conducive to reducing costs, decreasing losses, and increasing the gain of the power amplifier.

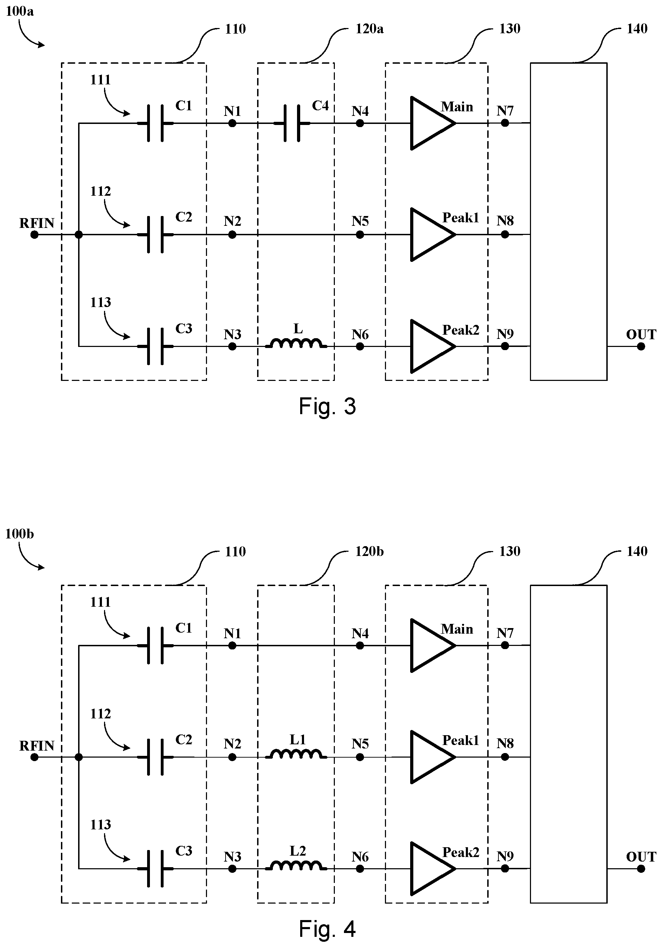

Fig. 3 illustrates a Doherty power amplifier according to some exemplary embodiments of the present disclosure. As shown in Fig. 3, the Doherty power amplifier 100a differs from the Doherty power amplifier 100 shown in Fig. 2 only in a specific circuit configuration of the phase shifting module. Only the differences between the Doherty power amplifier 100a and the Doherty power amplifier 100 shown in Fig. 2 will be described as follows, and the similarities thereof will not be repeated described.

A phase shifting module 120 of the Doherty power amplifier 100a comprises a phase shifting capacitor C4 and a phase shifting inductor L. A first end of the phase shifting capacitor C4 is electrically connected to the first power dividing output node N1, a second end of the phase shifting capacitor C4 is electrically connected to the first phase shifting output node N4, a first end of the phase shifting inductor L is electrically connected to the third power dividing output node N3, a second end of the phase shifting inductor L is electrically connected to the third phase shifting output node N6, and the phase shifting module 120a makes the second power dividing output node N2 directly to conduct with the second phase shifting output node N5 (e.g., conducted by conductive wires). The phase shifting capacitor C4 makes the phase of the first phase shifting output signal at the first phase shifting output node N4 lead the phase of the first power dividing output signal at the first power dividing output node N1 by the preset phase value (e.g., the preset phase value ranges from 60° to 100°). The phase shifting inductor L makes the phase of the third phase shifting output at the third phase shifting output node N6 lag to the phase of the third power dividing output signal at the third power dividing output node N3 by the preset phase value. Thus, the phase shifting module 120a makes the phase of the second phase shifting output signal lag to the phase of the first phase shifting output signal by the preset phase value, and makes the phase of the third phase shifting output signal lag to the phase of the second phase shifting output signal by the preset phase value. In some exemplary embodiments, the phase shifting capacitor C4 can be an integrated lumped capacitor, and the phase shifting inductor L can be an integrated lumped inductor.

Thus, the phase shifting module 120a of the Doherty power amplifier 100a shown in Fig. 3 further utilizes the phase shifting capacitor C4 to realize, and further reduces the utilization of inductors, further reducing the chip sizes and reducing costs.

Fig. 4 illustrates a Doherty power amplifier according to some exemplary embodiments of the present disclosure. As shown in Fig. 4, the Doherty power amplifier 100b differs from the Doherty power amplifier 100 shown in Fig. 2 only in another specific circuit configuration of the phase shifting module. Only the differences between the Doherty power amplifier 100b and the Doherty power amplifier 100 shown in Fig. 2 will be described as follows, and the similarities thereof will not be repeated described.

A phase shifting module 120b of the Doherty power amplifier 100b comprises a first phase shifting inductor L1 and a second phase shifting inductor L2. A first of the first phase shifting inductor L1 is electrically connected to the second power dividing output node N2, an second end of the first phase shifting inductor L1 is electrically connected to the second phase shifting output node N5, a first end of the second phase shifting inductor L2 is electrically connected to the third power dividing output node N3, a second end of the second phase shifting inductor L2 is electrically connected to the third phase shifting output node N6, and the phase shifting module 120b makes the first power dividing output node N1 to directly conduct to the first phase shifting output node N4 (e.g., conducted by conductive wires). The first phase shifting inductor L1 makes the phase of the second phase shifting output signal at the second phase shifting output node N5 lag to the phase of the second power dividing output signal at the second power dividing output node N2 the preset phase value (e.g., the preset phase value ranges from 60° to 100°), and the second phase shifting inductor L2 makes the phase of the third phase shifting output signal at the third phase shifting output node N6 lag to the phase of the third power dividing output signal at the third power dividing output node N3 twice the preset phase value (i.e., lagged 120° to 200°. In other words, the second phase shifting inductor L2 makes the phase of the third phase shifting output signal at the third phase shifting output node N6 lag to the phase of the second power dividing output signal at the second power dividing output node N2 by the preset phase value. Thus, the phase shifting module 120b makes the phase of the second phase shifting output signal lag to the phase of the first phase shifting output signal by the preset phase value, and makes the phase of the third phase shifting output signal lag to the phase of the second phase shifting output signal by the preset phase value. In some exemplary embodiments, the first phase shifting inductor L1 and the second phase shifting inductor L2 can be integrated lumped inductors. In addition, in some exemplary embodiments, the second phase shifting inductor L2 can be formed by connecting two first phase shifting inductors L1 in series.

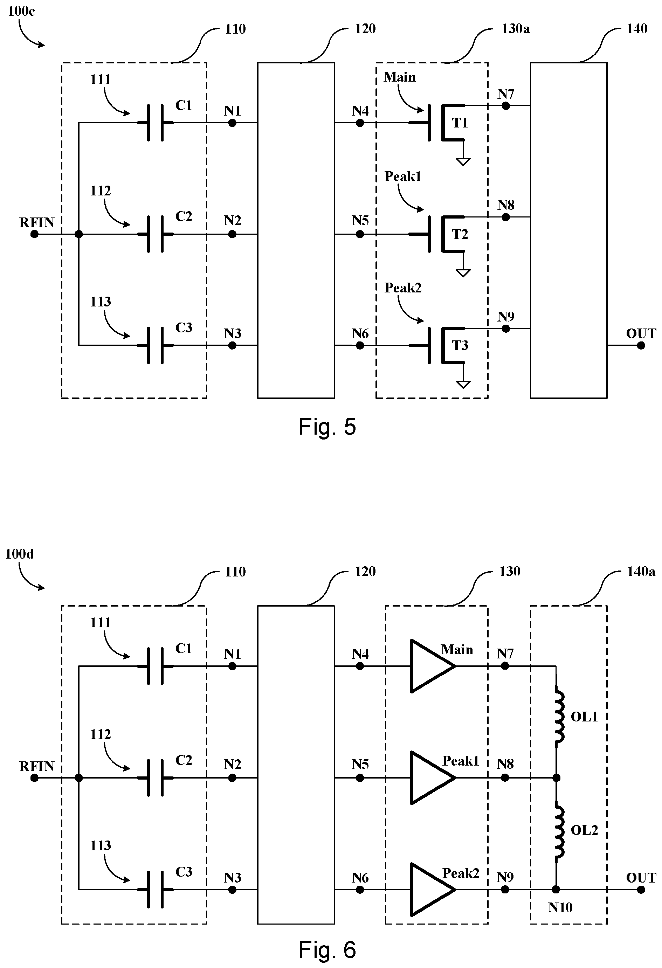

Fig. 5 illustrates a Doherty power amplifier according to some exemplary embodiments of the present disclosure. As shown in Fig. 5, the Doherty power amplifier 100c differs from the Doherty power amplifier 100 shown in Fig. 2 only in a specific circuit configuration of an amplifying module. Only the differences between the Doherty power amplifier 100c and the Doherty power amplifier 100 shown in Fig. 2 will be described as follows, and the similarities thereof will not be repeated described.

The amplifying module 130a of the Doherty power amplifier 100c comprises a main amplifier Main, a first peak amplifier Peak1, and a second peak amplifier Peak2. Each of the main amplifier Main, the first peak amplifier Peak1, and the second peak amplifier Peak2 comprises a transistor (e.g., field effect transistor). Specifically, the main amplifier Main comprises a first transistor T1, a gate electrode of the first transistor T1 is electrically connected to the first phase shifting output node N4, a source electrode of the first transistor T1 is grounded, and a drain electrode of the first transistor T1 is electrically connected to the main amplifying signal output node N7. The first peak amplifier Peak1 comprises a second transistor T2, a gate electrode of the second transistor T2 is electrically connected to the second phase shifting output node N5, a source electrode of the second transistor T2 is grounded, and a drain electrode of the second transistor T2 is electrically connected to the first peak amplifying signal output node N8. The second peak amplifier Peak2 comprises a third transistor T3, a gate electrode of the third transistor T3 is electrically connected to the third phase shifting output node N6, a source electrode of the third transistor T3 is grounded, and a drain electrode of the third transistor T3 is electrically connected to the second peak amplifying signal output node N9. In some exemplary embodiments, each of the main amplifier Main, the first peak amplifier Peak1, and the second peak amplifier Peak2 can comprise a plurality of field effect transistors operating in parallel, and the plurality of parallel field effect transistors are functionally similar to the signal field effect transistor. The amplifying module is realized by transistors, and especially field effect transistors, conducive to a high integration of the Doherty power amplifier.

Fig. 6 illustrates a Doherty power amplifier according to some exemplary embodiments of the present disclosure. As shown in Fig. 6, the Doherty power amplifier 100d differs from the Doherty power amplifier 100 shown in Fig. 2 only in a specific circuit configuration of the output power combining module. Only the differences between the Doherty power amplifier 100d and the Doherty power amplifier 100 shown in Fig. 2 will be described as follows, and the similarities thereof will not be repeated described.

The output power combining module 140a of the Doherty power amplifier 100d comprises a first compensation inductor OL1 and a second compensation inductor OL2. A first end of the first compensation inductor OL1 is electrically connected to the main amplifying signal output node N7, a second end of the first compensation inductor OL1 is electrically connected to the first peak amplifying signal output node N8, a first end of the second compensation inductor OL2 is electrically connected to the first peak amplifying signal output node N8, a second end of the second compensation inductor OL2 is electrically connected to a combining node N10, and an inductance value of the first compensation inductor OL1 is greater than an inductance value of the second compensation inductor OL2. In the output power combining module 140a, in conjunction with parasitic capacitance and compensated capacitance of each amplifier, each of the first compensation inductor OL1 and the second compensation inductor OL2 forms a CLC Pi-network to satisfy the impedance matching relationship for the merging network during two states for back-off and saturation. A main amplifying signal is transmitted to the combining node N10 after being transmitted by the first compensation inductor OL1 and the second compensation inductor OL2, a first peak amplifying signal is transmitted to the combining node N10 after being transmitted by the second compensation inductor OL2, and a second peak amplifying signal is directly transmitted to the combining node N10 after being transmitted from second peak amplifying signal output node N9. At the combining node N10, the phase of the main amplifying signal, the first peak amplifying signal, and the second peak amplifying signal are the same. The main amplifying signal, the first peak amplifying signal, and the second peak amplifying signal combine at the combining node N10 and are output from the signal output node OUT.

In some exemplary embodiments, at least one of the first compensation inductor OL1 and the second compensation inductor OL2 can be implemented by a high-quality-factor surface-mount inductor to reduce losses of the merging network.

In some exemplary embodiments, the first compensation inductor OL1 and the second compensation inductor OL2 can also be connected as follows: the first end of the first compensation inductor OL1 is electrically connected to the main amplifying signal output node N7, the second end of the first compensation inductor OL1 is electrically connected to the combining node N10, the first end of the second compensation inductor OL2 is electrically connected to the first peak amplifying signal output node N8, and the second end of the second compensation inductor OL2 is electrically connected to the combining node N10. The inductance value of the first compensation inductor OL1 is greater than the inductance value of the second compensation inductor OL2. The first compensation inductor OL1 and the second compensation inductor OL2 are configured to make the phase of the main amplifying signal, the phase of the first peak amplifying signal, and the phase of the second peak amplifying signal the same at the combining node N10. The main amplifying signal, the first peak amplifying signal, and the second peak amplifying signal combine at the combining node N10 and are output from the signal output node OUT.

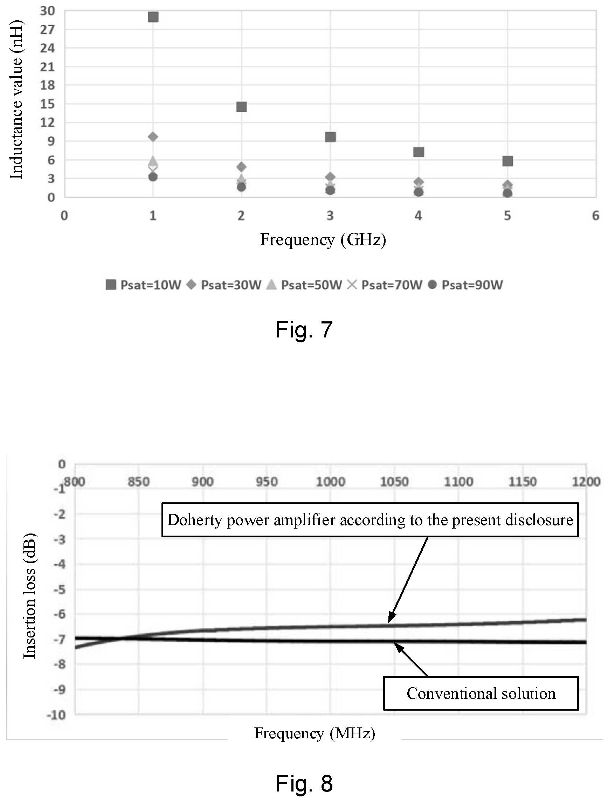

Fig. 7 illustrates the relationship between the inductance value of the first compensation inductor OL1, and the operating frequency. As shown in Fig. 7, the inductance value of the first compensation inductor OL1 is approximately inversely proportional to the operating frequency and the saturation power. Therefore, in the application scenario with low-frequency and low-power, the inductance value of the first compensation inductor OL1 can be larger. For example, in a case where the operating frequency is 2 GHz and the saturation power is 10 W, the inductance value of the first compensation inductor OL1 is close to 15 nH. Such a large inductance to be realized by bonding wire is impossible, while the first compensation inductor OL1 realized by an integrated lumped inductor will inductance unacceptable losses. Under comprehensively considering performance, realizability, and economy, the technical solution according to each exemplary embodiment of the present disclosure adopts a discrete surface-mount inductor to realize the first compensation inductor OL1 and the second compensation inductor OL2.

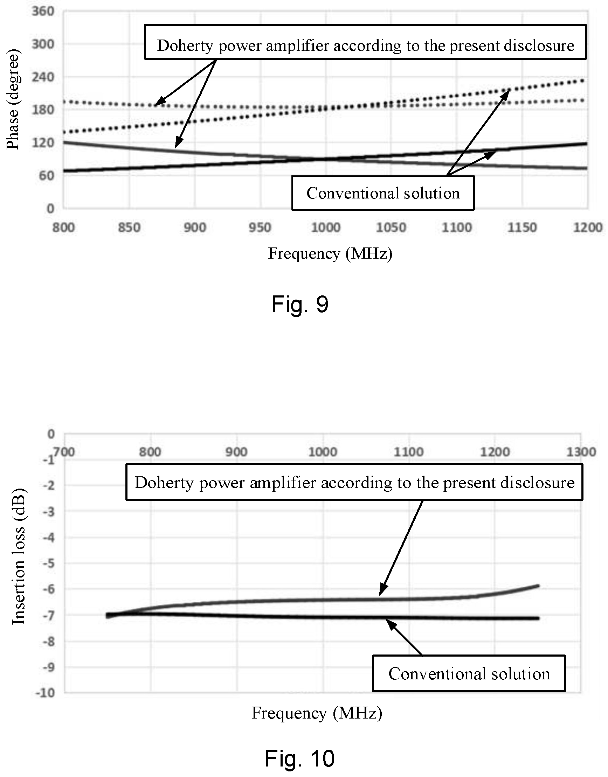

Fig. 8 and Fig. 9 illustrate comparison results between a Doherty power amplifier according to the present disclosure and a conventional Doherty power amplifier in power distribution and phase shift. The Doherty power amplifier according to the present disclosure adopts the input power dividing module and the phase shifting module shown in Fig. 3, and the conventional Doherty power amplifier adopts the power dividing and phase shifting circuit shown in Fig. 1.

Fig. 8 illustrates insertion losses at the input end of the main amplifier Main of the Doherty power amplifier according to the present disclosure and the conventional Doherty power amplifier. Under the operation frequency as shown, the insertion losses of both are approximately the same, especially in the range of 800 MHz to about 830 MHz, the insertion loss at the input end of the main amplifier Main of the Doherty power amplifier according the present disclosure is lower than the insertion loss at the input end of the main amplifier Main of the conventional Doherty power amplifier.

Fig. 9 illustrates the phase difference between the signal at the input end of the main amplifier Main and the signal at the output end of the first peak amplifier Peak1 in the Doherty power amplifier according to the present disclosure and the conventional Doherty power amplifier, and the phase difference between the signal at the input end of the first peak amplifier Peak1 and the signal at the input end of the second peak amplifier Peak2 in the Doherty power amplifier according to the present disclosure and the conventional Doherty power amplifier. The solid lines show the phase difference between the signal at the input end of the main amplifier Main and the signal at the input end of the first peak amplifier Peak1, and the dotted lines show the phase difference between the signal at the input end of the first peak amplifier Peak1, and the signal at the input end of the second peak amplifier Peak2. As shown in Fig. 9, compared with the Doherty power amplifier according to the present disclosure and the conventional Doherty power amplifier, the phase differences in the above two aspects are substantially consistent.

Thus, as shown in Figs. 8 and 9, the Doherty power amplifier according to the present disclosure satisfies the requirements of power distribution and phase shifting in a three-channel Doherty power amplifier.

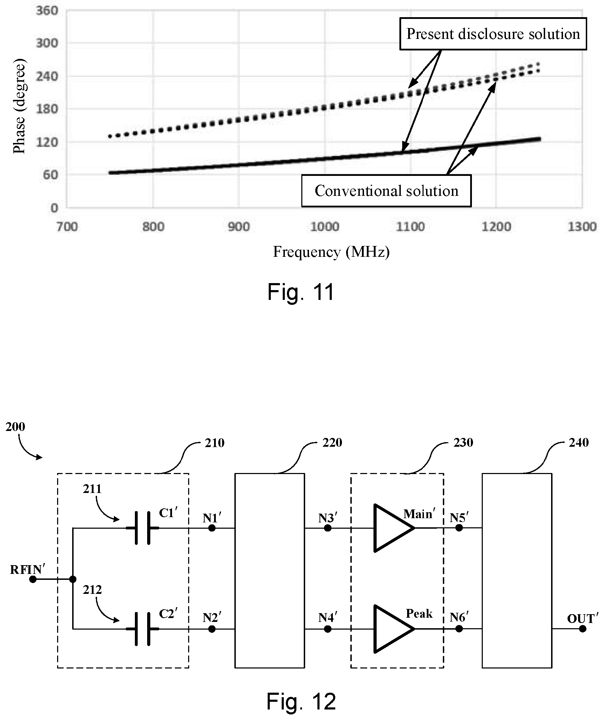

Fig. 10 and Fig. 11 illustrate comparison results between another Doherty power amplifier according to the present disclosure and a conventional Doherty power amplifier in power distribution and phase shift. The Doherty power amplifier, according to the present disclosure, adopts the input power dividing module and the phase shifting module shown in Fig. 4, and the conventional Doherty power amplifier adopts the power dividing and phase shifting circuit shown in Fig. 1.

Fig. 10 illustrates insertion losses at the input end of the main amplifier Main of the Doherty power amplifier according to the present disclosure and the conventional Doherty power amplifier. Under the operation frequency as shown, the insertion losses of both are approximately the same, especially at 750 MHz, the insertion loss at the input end of the main amplifier Main of the Doherty power amplifier, according to the present disclosure, is lower than the insertion loss at the input end of the main amplifier Main of the conventional Doherty power amplifier.

Fig. 11 illustrates the phase difference between the signal at the input end of the main amplifier Main and the signal at the input end of the first peak amplifier Peak1 in the Doherty power amplifier according to the present disclosure and the conventional Doherty power amplifier, and the phase difference between the signal at the input end of the first peak amplifier Peak1 and the signal at the input end of the second peak amplifier Peak2 in the Doherty power amplifier according to the present disclosure and the conventional Doherty power amplifier. The solid lines show the phase difference between the signal at the input end of the main amplifier Main and the signal at the input end of the first peak amplifier Peak1, and the dotted lines show the phase difference between the signal at the input end of the first peak amplifier Peak1 and the signal at the input end of the second peak amplifier Peak2. As shown in Fig. 11, compared with the Doherty power amplifier according to the present disclosure and the conventional Doherty power amplifier, the phase differences in the above two aspects are substantially consistent.

Thus, as shown in Figs. 10 and 11, the Doherty power amplifier according to the present disclosure satisfies the requirements of power distribution and phase shifting in a three-channel Doherty power amplifier.

By the above analysis, the Doherty power amplifier according to the present disclosure utilizes capacitors to implement the input power dividing module and avoids utilizing inductors, thus the chip sizes are reduced, conducive to reducing costs, decreasing losses, and increasing the gain of the power amplifier. Furthermore, at least one of the first compensation inductor and the second compensation inductor can be implemented by a high-quality-factor surface-mount inductor to reduce losses of the merging network.

It should be understood that the input power dividing module and the phase shifting module described in the present disclosure are not limited to the exemplary embodiments shown in Figs. 2 to 6, and can be widely implemented. Fig. 12 illustrates another Doherty power amplifier according to some exemplary embodiments of the present disclosure. As shown in Fig. 12, the Doherty power amplifier 200 is a two-channel integrated Doherty power amplifier and comprises an input power dividing module 210, a phase shifting module 220, an amplifying module 230, and an output power combining module 240. The Doherty power amplifier 100 amplifies a signal to be amplified and input from a signal input node RFIN', and outputs the amplified signal at a signal output node OUT'.

The input power dividing module 110 is configured to divide the signal to be amplified and input from the signal input node RFIN', according to a preset power distribution ratio, and output the divided signals through the corresponding power dividing circuits, for processing by subsequent modules. In the Doherty power amplifier 200 shown in Fig. 12, the input power dividing module 210 comprises a first power dividing circuit 211 and a second power dividing circuit 212. A first end of a first power dividing capacitor C1' of the first power dividing circuit 211 is electrically connected to the signal input node RFIN', and a second end of the first power dividing capacitor C1' is electrically connected to a first power dividing output node N1'. A first end of a second power dividing capacitor C2' of the second power dividing circuit 212 is electrically connected to the signal input node RFIN', and the second end of the second power dividing capacitor C2' is electrically connected to a second power dividing output node N2'. In this way, the signal to be amplified and input from the signal input node RFIN', is divided into two signals with the required power, and transmitted to the subsequent circuit for processing by two power dividing circuits, respectively.

According to some exemplary embodiments, the first power dividing capacitor C1' and the second power dividing capacitor C2' can be integrated lumped capacitors. It should be understood that any other appropriate capacitor is possible, and the embodiments of the present disclosure do not impose any restrictions on the specific type of capacitor to operate as a power dividing capacitor.

As non-limiting examples, the capacitance values of the first power dividing capacitor C1' and the second power dividing capacitor C2' can be calculated according to Equations 1 and 2 in the above-described. That is to say, in the above Equations, setting the power ratio R_P2 of the output signal of the third power dividing circuit to zero achieves the requirement.

The phase shifting module 220 is configured to: receive signals output from the first power dividing output node N1' and the second power dividing output node N2', perform phase shifting processes, and then output the corresponding signals at the first phase shifting output node N3' and the second phase shifting node N4', respectively. Specifically, the phase shifting module 220 is configured to: receive the first power dividing output signal at the first power dividing output node N1' and output the first phase shifting output signal at the first phase shifting output node N3', and receive the second power dividing output signal at the second power dividing output node N2' and output the second phase shifting output signal at the second phase shifting output node N4', where the phase of the second phase shifting output signal lags to the phase of the first phase shifting output signal by a preset phase value. According to some exemplary embodiments, the preset value ranges from 60° to 100°. It should be understood that the phase shifting module 120 can be implemented by any appropriate form of circuit configuration, provided it is capable of implementing the phase shifting processing described above for each power dividing output signal. The specific circuit configuration of the phase shifting module 220 is described in detail as follows.

The amplifying module 230 is configured to: receive the phase shifting output signals from the first phase shifting output node N3' and the second phase shifting output node N4', perform amplifying processes, and then output the corresponding signals at a main amplifying signal output node N5' and a peak amplifying signal output node N6', respectively. Specifically, the amplifying module 230 comprises a main amplifier Main' and a peak amplifier Peak. The main amplifier Main' is configured to: receive the first phase shifting output signal from the first phase shifting output node N3', and output the main amplifying signal from the main amplifying signal output node N5'. The peak amplifier Peak is configured to: receive the second phase shifting output signal at the second phase shifting output node N4', and output the peak amplifying signal at the peak amplifying signal output node N6'.

The output power combining module 240 is configured tos: receive the main amplifying signal from the main amplifying signal output node N5' and receive the peak amplifying signal from the peak amplifying signal output node N6', make the main amplifying signal and the peak amplifying signal the same phase, and combine and output the main amplifying signal and the peak amplifying signal from the signal output node OUT'. It should be understood that the output power combining module 240 can be employed with any appropriate form of circuit configuration, provided it is capable of implementing the combining output described above for each amplifying signal. The specific circuit configuration of the output power combining module 240 is described in detail as follows.

In some exemplary embodiments, the input power dividing module 210 and the phase shifting module 220 are integrated in a die, the main amplifier Main' and the peak amplifier Peak are integrated in another die, and the latter die is electrically connected to the former die by bonding wires. In other exemplary embodiments, the input power dividing module 210 and the phase shifting module 220 are integrated in different dies, and the different dies are electrically connected by bonding wires. Furthermore, the same die or different dies described above can be in a single package, and the output power combining module 240 is implemented in a non-integrated way, for example, connecting to the package by bonding wires or through holes.

By the above analysis, the Doherty power amplifier 200 shown in Fig. 12 utilizes capacitors to implement the input power dividing module 210 and avoids utilizing inductors, thus the chip sizes are reduced, conducive to reducing costs, decreasing losses, and increasing the gain of the power amplifier.

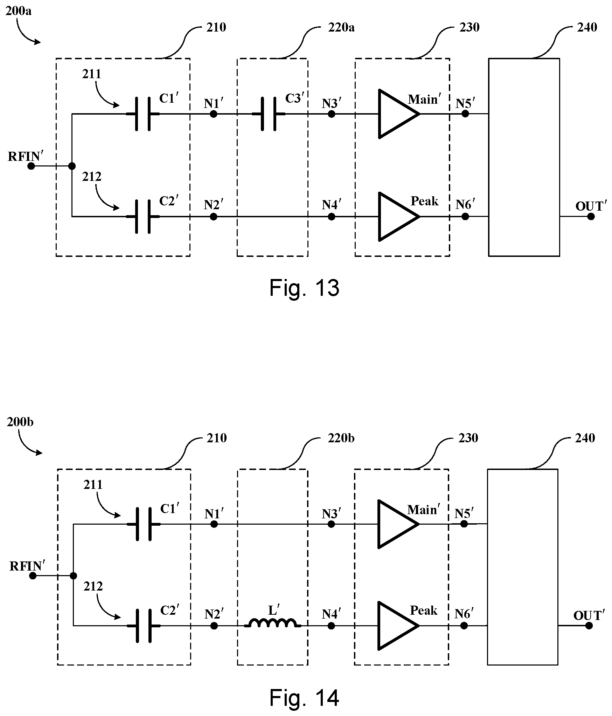

Fig. 13 illustrates a Doherty power amplifier according to some exemplary embodiments of the present disclosure. As shown in Fig. 13, the Doherty power amplifier 200a differs from the Doherty power amplifier 200 shown in Fig. 12 only in a specific circuit configuration of the phase shifting module. Only the differences between the Doherty power amplifier 200a and the Doherty power amplifier 200 shown in Fig. 12 will be described as follows, and the similarities thereof will not be repeated described.

A phase shifting module 220a of the Doherty power amplifier 200a comprises a phase shifting capacitor C3'. A first of the phase shifting capacitor C3' is electrically connected to the first power dividing output node N1', a second end of the phase shifting capacitor C3' is electrically connected to the first phase shifting output node N3', and the phase shifting module 220a makes the second power dividing output node N2' to directly conduct to the second phase shifting output node N4' (e.g., conducted by conductive wires). The phase shifting capacitor C3' makes the phase of the first phase shifting output signal at the first phase shifting output node N3' lead the phase of the first power dividing output signal at the first power dividing output node N1' by a preset phase value (e.g., the preset phase value ranges from 60° to 100°). Thus, the phase shifting module 220a makes the phase of the second phase shifting output signal lag to the phase of the first phase shifting output signal by the preset phase value. In some exemplary embodiments, the phase shifting capacitor C3' can be an integrated lumped capacitor.

Thus, the phase shifting module 220a of the Doherty power amplifier 200a shown in Fig. 13 further utilizes the phase shifting capacitor C3' to realize, and further reduces the utilization of inductors, further reducing the chip sizes and reducing costs.

Fig. 14 illustrates a Doherty power amplifier according to some exemplary embodiments of the present disclosure. As shown in Fig. 14, the Doherty power amplifier 200b differs from the Doherty power amplifier 200 shown in Fig. 12 only in another specific circuit configuration of the phase shifting module. Only the differences between the Doherty power amplifier 200b and the Doherty power amplifier 200 shown in Fig. 12 will be described as follows, and the similarities thereof will not be repeated described.

A phase shifting module 220b of the Doherty power amplifier 200b comprises a phase shifting inductor L'. A first of the phase shifting inductor L' is electrically connected to the second power dividing output node N2', a second end of the phase shifting inductor L' is electrically connected to the second phase shifting output node N4', and the phase shifting module 220b makes the first power dividing output node N1' to directly conduct to the first phase shifting output node N3' (e.g., conducted by conductive wires). The phase shifting inductor L' makes the phase of the second phase shifting output signal at the second phase shifting output node N4' lag to the phase of the second power dividing output signal at the second power dividing output node N2' by a preset phase value (e.g., the preset phase value ranges from 60° to 100°). Thus, the phase shifting module 220b makes the phase of the second phase shifting output signal lag to the phase of the first phase shifting output signal by the preset phase value. In some exemplary embodiments, the phase shifting inductor L1' can be an integrated lumped inductor.

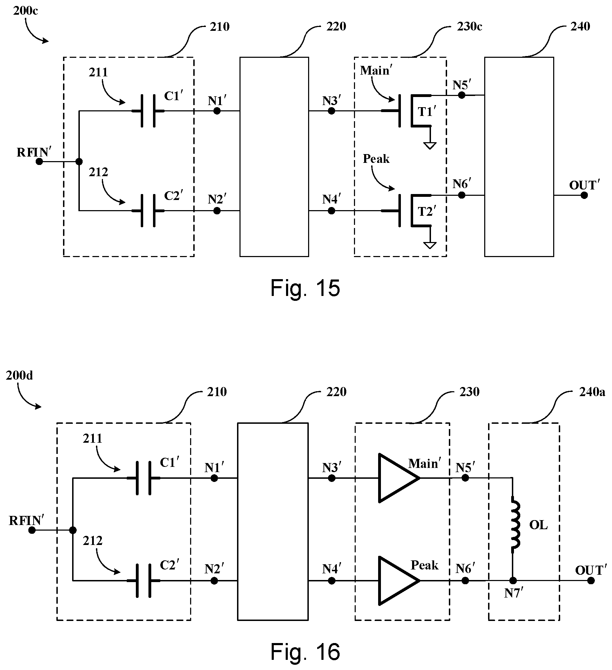

Fig. 15 illustrates a Doherty power amplifier according to some exemplary embodiments of the present disclosure. As shown in Fig. 15, the Doherty power amplifier 200c differs from the Doherty power amplifier 200 shown in Fig. 12 only in a specific circuit configuration of an amplifying module. Only the differences between the Doherty power amplifier 200c and the Doherty power amplifier 200 shown in Fig. 12 will be described as follows, and the similarities thereof will not be repeated described.

The amplifying module 230a of the Doherty power amplifier 200c comprises a main amplifier Main' and a peak amplifier Peak. Each of the main amplifier Main' and the peak amplifier Peak comprises a transistor (e.g., a field effect transistor). Specifically, the main amplifier Main' comprises a first transistor T1', a gate electrode of the first transistor T1' is electrically connected to the first phase shifting output node N3', a source electrode of the first transistor T1' is grounded, and a drain electrode of the first transistor T1' is electrically connected to the main amplifying signal output node N5'. The peak amplifier Peak comprises a second transistor T2', a gate electrode of the second transistor T2' is electrically connected to the second phase shifting output node N4', a source electrode of the second transistor T2' is grounded, and a drain electrode of the second transistor T2' is electrically connected to the signal output node N6' of the peak amplifier. In some exemplary embodiments, each of the main amplifier Main' and the peak amplifier can comprise a plurality of field effect transistors operating in parallel, and the plurality of parallel field effect transistors are functionally similar to the signal field effect transistor. The amplifying module is realized by transistors, and especially field effect transistors, conducive to a high integration of the Doherty power amplifier.

Fig. 16 illustrates a Doherty power amplifier according to some exemplary embodiments of the present disclosure. As shown in Fig. 16, the Doherty power amplifier 200d differs from the Doherty power amplifier 200 shown in Fig. 12 only in a specific circuit configuration of the output power combining module. Only the differences between the Doherty power amplifier 200d and the Doherty power amplifier 200 shown in Fig. 12 will be described as follows, and the similarities thereof will not be repeated described.

The output power combining module 240a of the Doherty power amplifier 200d comprises a compensation inductor OL. A first end of the compensation inductor OL is electrically connected to the main amplifying signal output node N5', and a second end of the compensation inductor OL is electrically connected to the combining node N7'. In the output power combining module 240a, in conjunction with parasitic capacitance and compensated capacitance of each amplifier, the compensation inductor OL forms a CLC Pi-network to satisfy the impedance matching relationship for the merging network during two states for back-off and saturation. A main amplifying signal is transmitted to the combining node N7' after being transmitted by the compensation inductor OL, and a peak amplifying signal is directly transmitted to the combining node N7' after being transmitted from the peak amplifying signal output node N6'. At the combining node N7', a phase of the main amplifying signal and a phase of the peak amplifying signal are the same. The main amplifying signal and the peak amplifying signal combine at the combining node N7', and are output from the signal output node OUT. In some exemplary embodiments, the compensation inductor OL can be implemented by a high-quality-factor surface-mount inductor.

By the above analysis, the integrated Doherty power amplifier utilizes capacitors to implement the input power dividing module and avoids utilizing inductors, thus the chip sizes are reduced, conducive to reducing costs, decreasing losses, and increasing the gain of the power amplifier. Furthermore, the compensation inductor can be implemented by a high-quality-factor surface-mount inductor to reduce losses of the merging network.

Terms used in the present disclosure are only used to describe the embodiments in the present disclosure, and are not intended to limit the present disclosure. As used in the present disclosure, the singular forms "a", "an", and "the" are intended to include the plural forms as well, unless the context clearly indicates otherwise. It should be further understood that the terms "comprises" and "comprising" when used in the present disclosure specify the presence of stated features but do not preclude the presence or addition of one or more other features. As used in the present disclosure, the term "and/or" includes any and all combinations of one or more of the associated listed items. It should be understood that, although the terms "first", "second", "third", and so on may be used in the present disclosure to describe various features, these features should not be limited by these terms. These terms are only used to distinguish one feature from another.

Unless otherwise defined, all terms (including technical and scientific terms) used in the present disclosure have the same meaning as commonly understood by one having ordinary skill in the art to which this disclosure belongs. It should be further understood that terms, such as those defined in commonly used dictionaries, should be interpreted as having a meaning that is consistent with their meaning in the relevant art and/or the context of the present specification, and should not be interpreted in an idealized or overly formal sense unless expressly defined in the present disclosure.

In the description herein, the term "one embodiment", "some embodiments", "an example", "a specific example", or "some examples" or the like means that a particular feature, structure, material, or characteristic described in connection with the embodiment or example is included in at least one embodiment or example of the present disclosure. In this specification, exemplary expressions with respect to the above terms are not necessarily directed to the same embodiment or example. Furthermore, the particular features, structures, materials, or characteristics described may be combined in an appropriate manner into any one or more embodiments or examples. Moreover, without contradicting each other and without violating the technical principles, different embodiments or examples and features of different embodiments or examples described in this specification may be combined and assembled by a person having ordinary skills in the art, or some technical features may be omitted from different embodiments or examples described in this specification, and embodiments or examples derived based on such combination, assembly or omission are also regarded as falling within the scope of the present disclosure.

Although the present disclosure has been described in detail in connection with some exemplary embodiments, it is not to be limited to the specific form described therein. Rather, the scope of the present disclosure is defined only by the appended claims.

## Claims

1. A Doherty power amplifier, comprising:

    an input power dividing module, comprising:

    a first power dividing circuit, wherein a first end of a first power dividing capacitor of the first power dividing circuit is electrically connected to a signal input node, and a second end of the first power dividing capacitor is electrically connected to a first power dividing output node; and
    a second power dividing circuit, wherein a first end of a second power dividing capacitor of the second power dividing circuit is electrically connected to the signal input node, and a second end of the second power dividing capacitor is electrically connected to a second power dividing output node;

    a phase shifting module, configured to: receive a first power dividing output signal from the first power dividing output node and output a first phase shifting output signal at a first phase shifting output node, and receive a second power dividing output signal from a second power dividing output node and output a second phase shifting output signal at a second phase shifting output node, wherein a phase of the second phase shifting output signal lags to a phase of the first phase shifting output signal by a preset phase value;
    an amplifying module, comprising:

    a main amplifier, configured to: receive the first phase shifting output signal, and output a main amplifying signal at a main amplifying signal output node; and
    a first peak amplifier, configured to: receive the second phase shifting output signal, and output a first peak amplifying signal at a first peak amplifying signal output node; and

    an output power combining module, configured to: receive the main amplifying signal and the first peak amplifying signal, make a phase of the main amplifying signal and a phase of the first peak amplifying signal the same, and combine and output the main amplifying signal and the first peak amplifying signal.

2. The Doherty power amplifier according to claim 1, wherein the first power dividing capacitor and the second power dividing capacitor are integrated lumped capacitors.

3. The Doherty power amplifier according to claim 1, wherein the phase shifting module comprises a phase shifting capacitor, a first end of the phase shifting capacitor is electrically connected to the first power dividing output node, a second end of the phase shifting capacitor is electrically connected to the first phase shifting output node, and the phase shifting module makes the second power dividing output node and the second phase shifting output node electrically connected.

4. The Doherty power amplifier according to claim 3, wherein the phase shifting capacitor is an integrated lumped capacitor.

5. The Doherty power amplifier according to claim 1, wherein the phase shifting module makes the first power dividing output node and the first phase shifting output node electrically connected, and the phase shifting module comprises a phase shifting inductor, a first end of the phase shifting inductor is electrically connected to the second phase shifting output node, and a second end of the phase shifting inductor is electrically connected to the second phase shifting output node.

6. The Doherty power amplifier according to claim 5, wherein the phase shifting inductor is an integrated lumped inductor.

7. The Doherty power amplifier according to claim 1, wherein

the main amplifier comprises a first transistor, a gate electrode of the first transistor is electrically connected to the first phase shifting output node, a source electrode of the first transistor is grounded, and a drain electrode of the first transistor is electrically connected to the main amplifying signal output node; and
the first peak amplifier comprises a second transistor, a gate electrode of the second transistor is electrically connected to the second phase shifting output node, a source electrode of the second transistor is grounded, and a drain electrode of the second transistor is electrically connected to the first peak amplifying signal output node.

8. The Doherty power amplifier according to claim 1, wherein the output power combining module comprises a compensation inductor, a first end of the compensation inductor is electrically connected to the main amplifying signal output node, and a second end of the compensation inductor is electrically connected to the first peak amplifying signal output node.

9. The Doherty power amplifier according to claim 8, wherein the compensation inductor is a surface-mount inductor.

10. The Doherty power amplifier according to claim 1, wherein

the input power dividing module further comprises a third power dividing circuit, a first end of a third power dividing capacitor of the third power dividing circuit is electrically connected to the signal input node, and a second end of the third power dividing capacitor is electrically connected to a third power dividing output node;
the phase shifting module is configured to: receive the third power dividing output signal from the third power dividing output node and output the third phase shifting output signal at the third phase shifting output signal node, wherein a phase of the third phase shifting output signal lags to the phase of the second phase shifting output signal by the preset phase value;
the amplifying module further comprises a second peak amplifier, configured to: receive the third phase shifting output signal, and output a second peak amplifying signal at the second peak amplifying signal output node; and
the output power combining module, further configured to: receive the second peak amplifying signal, make a phase of the main amplifying signal, a phase of the first peak amplifying signal, and a phase of the second peak amplifying signal the same, and combine and output the main amplifying signal, the first peak amplifying signal, and the second peak amplifying signal.

11. The Doherty power amplifier according to claim 10, wherein the first power dividing capacitor, the second power dividing capacitor, and the third power dividing capacitor are integrated lumped capacitors.

12. The Doherty power amplifier according to claim 10, wherein the phase shifting module comprises a phase shifting capacitor and a phase shifting inductor, a first end of the phase shifting capacitor is electrically connected to the first power dividing output node, a second end of the phase shifting capacitor is electrically connected to the first phase shifting output node, a first end of the phase shifting inductor is electrically connected to the third power dividing output node, a second end of the phase shifting inductor is electrically connected to the third phase shifting output node, and the phase shifting module makes the second power dividing output node to conduct with the second phase shifting output node.

13. The Doherty power amplifier according to claim 12, wherein the phase shifting capacitor is an integrated lumped capacitor, and the phase shifting inductor is an integrated lumped inductor.

14. The Doherty power amplifier according to claim 10, wherein the phase shifting module comprises a first phase shifting inductor and a second phase shifting inductor, a first end of the first phase shifting inductor is electrically connected to the second power dividing output node, a second end of the first phase shifting inductor is electrically connected to the second phase shifting output node, a first end of the second phase shifting inductor is electrically connected to the third power dividing output node, a second end of the second phase shifting inductor is electrically connected to the third phase shifting output node, and the phase shifting module makes the first power dividing output node to conduct with the first phase shifting output node.

15. The Doherty power amplifier according to claim 14, wherein the first phase shifting inductor and the second phase shifting inductor are integrated lumped inductors.

16. The Doherty power amplifier according to claim 15, wherein the second phase shifting inductor is formed by two integrated lumped capacitors in series.

17. The Doherty power amplifier according to claim 10, wherein

the main amplifier comprises a first transistor, a gate electrode of the first transistor is electrically connected to the first phase shifting output node, a source electrode of the first transistor is grounded, and a drain electrode of the first transistor is electrically connected to the main amplifying signal output node; and
the first peak amplifier comprises a second transistor, a gate electrode of the second transistor is electrically connected to the second phase shifting output node, a source electrode of the second transistor is grounded, and a drain electrode of the second transistor is electrically connected to the first peak amplifying signal output node; and
the second peak amplifier comprises a third transistor, a gate electrode of the third transistor is electrically connected to the third phase shifting output node, a source electrode of the third transistor is grounded, and a drain electrode of the third transistor is electrically connected to the second peak amplifying signal output node.

18. The Doherty power amplifier according to claim 10, wherein the output power combining module comprises a first compensation inductor and a second compensation inductor, a first end of the first compensation inductor is electrically connected to the main amplifying signal output node, a second end of the first compensation inductor is electrically connected to the first peak amplifying signal output node, a first end of the second compensation inductor is electrically connected to the first peak amplifying signal output node, a second end of the second compensation inductor is electrically connected to the second peak amplifying signal output node, and an inductance value of the first compensation inductor is greater than an inductance value of the second compensation inductor.

19. The Doherty power amplifier according to claim 18, wherein at least one of the first compensation inductor and the second compensation inductor is a surface-mount inductor.

20. The Doherty power amplifier according to claim 1, wherein the preset phase value ranges from 60° to 100°.

Fig. 1

Fig. 2

Fig. 3

Fig. 4

Fig. 5

Fig. 6

Fig. 7

Fig. 8

Fig. 9

Fig. 10

EP 4 773 505 A1

Fig. 11

Fig. 12

20

Fig. 13

Fig. 14

## Fig. 15

## Fig. 16

## INTERNATIONAL SEARCH REPORT

| International application No. |
|---|
| **PCT/CN2024/075168** |

### A. CLASSIFICATION OF SUBJECT MATTER

H03F3/213(2006.01)i

According to International Patent Classification (IPC) or to both national classification and IPC

### B. FIELDS SEARCHED

Minimum documentation searched (classification system followed by classification symbols)

IPC: H03F

Documentation searched other than minimum documentation to the extent that such documents are included in the fields searched

Electronic data base consulted during the international search (name of data base and, where practicable, search terms used)

CNTXT, CNKI, ENTXT, IEEE: 多赫蒂放大器, 功率放大器, 功率分配, 电容, 移相, 主放大器, 峰值放大器, 功率合成, Doherty, power amplifier, PA, power distributor, power splitter, capacitance, phase shift, main amplifier, carrier amplifier, peak power amplifier, power synthesis

### C. DOCUMENTS CONSIDERED TO BE RELEVANT

| Category* | Citation of document, with indication, where appropriate, of the relevant passages | Relevant to claim No. |
|---|---|---|
| A | CN 116325493 A (MITSUBISHI ELECTRIC CORPORATION) 23 June 2023 (2023-06-23) description, paragraphs 38-46, and figure 1 | 1-20 |
| A | CN 115021685 A (RADROCK (SHENZHEN) TECHNOLOGY CO., LTD.) 06 September 2022 (2022-09-06) entire document | 1-20 |
| A | CN 114123982 A (LANSUS TECHNOLOGIES INC.) 01 March 2022 (2022-03-01) entire document | 1-20 |
| A | US 2020204120 A1 (NXP USA, INC.) 25 June 2020 (2020-06-25) entire document | 1-20 |

☐ Further documents are listed in the continuation of Box C.　　☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **30 September 2024** | **10 October 2024** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/075168**

| Patent document cited in search report | | | Publication date (day/month/year) | Patent family member(s) | | | Publication date (day/month/year) |
|---|---|---|---|---|---|---|---|
| CN | 116325493 | A | 23 June 2023 | WO | 2022118445 | A1 | 09 June 2022 |
| | | | | JP | 7529042 | B2 | 06 August 2024 |
| | | | | US | 2023299721 | A1 | 21 September 2023 |
| CN | 115021685 | A | 06 September 2022 | WO | 2023216846 | A1 | 16 November 2023 |
| | | | | CN | 115021685 | B | 11 August 2023 |
| CN | 114123982 | A | 01 March 2022 | WO | 2023087627 | A1 | 25 May 2023 |
| US | 2020204120 | A1 | 25 June 2020 | EP | 3672068 | A1 | 24 June 2020 |
| | | | | EP | 3672068 | B1 | 24 August 2022 |
| | | | | US | 11146220 | B2 | 12 October 2021 |
| | | | | CN | 111342781 | A | 26 June 2020 |

Form PCT/ISA/210 (patent family annex) (July 2022)